# EUROPÄISCHE PATENTANMELDUNG

(11) **EP 3 480 955 A1**
(43) Veröffentlichungstag der Anmeldung: **08.05.2019**
(21) Anmeldenummer: 18000833.6
(22) Anmeldetag: 26.10.2018
(51) Int. Cl.: H03K 17/96

(54) **AKUSTISCHES BERÜHRUNGSSYSTEM**

(30) Priorität: 03.11.2017 CN 201711066880
(71) Anmelder: Diehl AKO Stiftung & Co. KG, 88239 Wangen (DE)
(72) Erfinder: LI, Yan, Nanjing, CN - 210046 (CN)
(74) Vertreter: Diehl Patentabteilung

(57) **Zusammenfassung**

Die vorliegende Erfindung betrifft ein akustisches Berührungssystem und ein Haushaltsgerät mit einem solchen akustischen Berührungssystem. Das akustische Berührungssystem umfasst: ein Panel mit einem Berührungsbereich; eine Leiterplatte, auf der ein akustischer Sensor vorgesehen ist, der jeweils einem entsprechenden Berührungsbereich zugeordnet ist; eine Steuereinrichtung, die dazu vorgesehen ist, Signale aus dem akustischen Sensor zu empfangen und weiter auszuwerten; und einen Zwischenkörper, der zwischen der Leiterplatte und dem Panel vorgesehen ist und so ausgebildet ist, dass eine Schallaufnahmefläche des akustischen Sensors von externer Umgebung gasdicht isoliert ist.

## Beschreibung

### Technisches Gebiet

Die vorliegende Erfindung betrifft das technische Gebiet der Haushaltsgeräte, insbesondere ein akustisches Berührungssystem sowie ein Haushaltsgerät mit einem solchen akustischen Berührungssystem.

### Stand der Technik

In den letzten Jahren finden Berührungssysteme auf dem Gebiet der Haushaltsgeräte immer weitere Anwendungen. Die meisten Berührungssysteme der auf dem Markt vorhandenen Haushaltsgeräte verwenden ein kapazitives Touch-Panel. Das kapazitive Touch-Panel arbeitet mit der Stromerfassung des menschlichen Körpers. Das kapazitive Touch-Panel erfasst die Kapazität zwischen zwei axialen Erfassungselektroden des Touch-Panels oder die Kapazitäten, die jeweils zwischen den beiden axialen Erfassungselektroden des Touch-Panels und der Erdung liegen, und die Größe der Kapazitätsänderung, die vor und nach dem Berühren durch ein berührendes Objekt, z. B. einen Finger, auftritt. Daher gibt es ein paar Probleme, die auf den Grundprinzipien kapazitiver Touch-Panels basieren: Das kapazitive Touch-Panel soll nicht aus Metall bestehen und muss aus einem nicht-leitenden Material (z. B. Kunststoff oder Glas) bestehen; das berührende Objekt muss ein Leiter sein, um die Kapazität zu beeinflussen, wobei die berührte Position nicht erfassbar ist, falls das berührende Objekt ein Isolator ist. Feuchtigkeit beeinträchtigt die Leistung des kapazitiven Touch-Panels, wohingegen aufgrund von Anwendungsgebieten der Haushaltsgeräte die Oberfläche des Touch-Panels häufig mit Wasser bedeckt wird, so dass die Leistung des kapazitiven Touch-Systems stark gestört werden kann.

Um die Unzulänglichkeiten des kapazitiven Touch-Panels zu beseitigen, ist aus dem Stand der Technik auch ein piezoelektrisches Touch-Panel bekannt, bei dem eine Sensoreinheit unter Verwendung eines piezoelektrischen Materials hergestellt werden muss, und bei dem mithilfe einer Vielzahl von piezoelektrischen Sensoreinheiten auf dem Substrat die äußere Druckverformung direkt erfasst und die Berührungs- bzw. Pressposition bestimmt wird, ohne das berührende Objekt zu beschränken. Basierend auf dem Grundprinzip des piezoelektrischen Touch-Panels reicht jedoch ein einfaches Berühren oder Tippen nicht aus, um eine ausreichende Verformungsmenge zum Bestimmen der Berührungsposition zu erzeugen. Piezoelektrische Touch-Panels benötigen normalerweise einen relativ großen Pressdruck, z. B. einen Pressdruck von 1 N bis 3 N. Um die Empfindlichkeit des Systems zu erhöhen, muss ferner die Schicht aus piezoelektrischem Material dünn ausgebildet sein, beispielsweise mit einer Dicke von ungefähr 0,7 mm. Dies erschwert weiterhin die Herstellung und erhöht somit die Herstellungskosten.

Daher lohnt es sich, eine Touch-Panel-Technik zu entwickeln, die auf eine Vielzahl von berührenden Objekttypen anwendbar ist, Panels unterschiedlicher Materialtypen verwenden kann und durch Feuchtigkeit und Pressdruck nicht beeinflussbar ist.

### Offenbarung der Erfindung

Die Aufgabe der vorliegenden Erfindung liegt darin, ein weit verbreitetes und zuverlässiges akustisches Berührungssystem bereitzustellen.

Ferner stellt die vorliegende Erfindung auch ein Haushaltsgerät mit einem akustischen Berührungssystem bereit.

Gemäß einem Aspekt der vorliegenden Erfindung ist die Aufgabe durch ein akustisches Berührungssystem gelöst, das Folgendes umfasst: ein Panel mit einem oder mehreren Berührungsbereichen; einen oder mehrere akustische Sensoren, der/die jeweils einem entsprechenden Berührungsbereich zugeordnet ist/sind; eine Steuereinrichtung, die dazu vorgesehen ist, Signale aus dem akustischen Sensor zu empfangen und weiter auszuwerten; und einen oder mehrere Zwischenkörper, der/die eine Schallaufnahmefläche des akustischen Sensors von externer Umgebung gasdicht isolieren kann/können.

Das Panel umfasst einen oder mehrere Berührungsbereiche, wobei jeder Berührungsbereich eine Funktion repräsentieren kann. Die jeweilige Funktion kann beispielsweise durch Anklopfen oder Antippen des Berührungsbereichs aktiviert werden. Dabei ist der akustische Sensor jeweils einem entsprechenden Berührungsbereich zugeordnet, um die durch Anklopfen oder Antippen des Panels erzeugte Schallwelle zu erfassen. Ein entsprechendes Signal der Schallwelle kann verdrahtet oder drahtlos an die Steuereinrichtung gesendet werden. Die Steuereinrichtung kann dazu vorgesehen werden, durch Auswerten des Signals des akustischen Sensors weiterhin den angeklopften bzw. angetippten Bereich zu bestimmen, um die Funktion zu aktivieren, die durch den angeklopften bzw. angetippten Bereich repräsentiert ist.

Da in der vorliegenden Erfindung Schallwellen erfasst werden, die beim Anklopfen bzw. Antippen des Panels von einem menschlichen Körperteil oder einem Gegenstand erzeugt werden, kann sich das berührende Objekt auf verschiedene Arten von Objekten beziehen. Beispielsweise kann das Objekt ein menschliches Körperteil wie einen Finger (einschließlich eines Fingers in einem Kunststoffhandschuh) sein, nichtleitende Objekte, wie Kunststoffobjekte, oder leitende Objekte, wie Metallstäbe usw. Somit können im Vergleich zu einem kapazitiven Berührungssystem im Stand der Technik mehrere Arten von berührenden Objekten das akustische Berührungssystem gemäß der vorliegenden Erfindung betätigen. Weil das Anklopfen bzw. Antippen des Panels nicht von Feuchtigkeit oder Wasser auf dem Panel gestört wird, liegt ferner der Vorteil des akustischen Berührungssystems gemäß der vorliegenden Erfindung gegenüber einem kapazitiven Berührungssystem noch darin, dass es nicht von Feuchtigkeit beeinflusst wird. Darüber hinaus erfasst die vorliegende Erfindung anstelle der Größe der Kraft, mit der das Panel gedrückt wird, die Schallwellen, die durch Anklopfen oder Antippen des Panels erzeugt werden. Daher ist die Größe der Kraft, mit der das Panel gedrückt wird, im Gegensatz zu einem piezoelektrischen Berührungspanel auch nicht beschränkt. Ferner ist die Dicke des akustischen Berührungssystems aufgrund der guten Übertragungseigenschaften der Schallwellen im Festkörper auch nicht beschränkt. Dies ist ein Vorteil des akustischen Berührungssystems gegenüber einem piezoelektrischen Berührungspanel.

Die Schallaufnahmefläche des akustischen Sensors ist gegenüber der externen Umgebung gasdicht isoliert, was Folgendes bedeutet: Der Zwischenkörper ist so ausgebildet, dass zwischen der Schallaufnahmefläche des akustischen Sensors und dem Panel kein mit der externen Umgebung kommunizierender Luftspalt besteht, wodurch sichergestellt wird, dass das Geräusch der externen Umgebung nicht über den Luftspalt direkt auf die Schallaufnahmefläche des akustischen Sensors übertragen wird und somit die Störung des akustischen Sensors vermieden wird. Im Rahmen der vorliegenden Anmeldung wird die "externe Umgebung" als die atmosphärische Umgebung verstanden, in der sich das gesamte akustische Berührungssystem befindet, d. h. das Schallfeld, in dem es sich befindet. Durch die gasdichte Isolierung der Schallaufnahmefläche des akustischen Sensors von der externen Umgebung werden jegliche Störfaktoren (z. B. Straßengeräusche) in der atmosphärischen Umgebung bzw. dem Schallfeld ausgeschlossen, in der bzw. dem sich das gesamte akustische Berührungssystem befindet. Im Allgemeinen können Geräusche von der externen Umgebung das Auswerten der Steuereinrichtung stören und somit die Zuverlässigkeit des Systems verringern. Zum Beispiel kann das Geräusch der externen Umgebung zum Aktivieren bestimmter Funktion führen, ohne dass dies gewünscht ist beziehungsweise ohne den Berührungsbereich anzuklopfen bzw. anzutippen. Dies kann vermieden werden, indem die Schallaufnahmefläche des akustischen Sensors von der externen Umgebung gasdicht isoliert wird.

Vorzugsweise umfasst das akustische Berührungssystem ferner eine Leiterplatte, wobei auf der Leiterplatte der eine oder die mehreren akustischen Sensoren vorgesehen ist/sind, und wobei zwischen dem Panel und der Leiterplatte der Zwischenkörper vorgesehen ist.

Vorzugsweise umfasst das akustische Berührungssystem ferner ein Gehäuse, das den Zwischenkörper, die Leiterplatte und die Steuereinrichtung aufnimmt. Das Gehäuse und das Panel sind so ausgebildet, dass der Zwischenkörper und die Leiterplatte gegeneinander zusammengedrückt sind. D. h., dass der durch das Gehäuse bereitgestellte Druck ein gasdichtes Anliegen des Zwischenkörpers und der Leiterplatte aneinander sicherstellt, wodurch der mit der externen Umgebung kommunizierende Luftspalt beseitigt und somit die Störsicherheit des Systems verbessert wird.

Beim Vorliegen von mehreren akustischen Sensoren ist/sind ferner der eine oder die mehreren Zwischenkörper so ausgebildet, dass die Schallaufnahmeflächen der mehreren akustischen Sensoren auch voneinander gasdicht isoliert sind, wodurch die Leistungsfähigkeit des Systems weiter verbessert wird. Dabei ist auch denkbar, mehrere Zwischenkörper vorzusehen, die jeweils voneinander beanstandet angeordnet sind. Dabei ist jeder der Zwischenkörper einem entsprechenden akustischen Sensor zugeordnet. Beispielsweise ist jeder Zwischenkörper einem akustischen Sensor zugeordnet oder jeder Zwischenkörper mehreren akustischen Sensoren zugeordnet. Wichtig ist, dass jeder Zwischenkörper sicherstellen muss, dass der entsprechend zugeordnete eine oder die entsprechend zugeordneten mehreren akustischen Sensoren von der externen Umgebung gasdicht isoliert sind. Vorzugsweise muss jeder Zwischenkörper auch sicherstellen, dass der entsprechend zugeordnete akustische Sensor von anderen akustischen Sensoren gasdicht isoliert ist.

Vorteilhafter Weise liegen der Zwischenkörper und die Schallaufnahmefläche des akustischen Sensors gasdicht aneinander an. Vorzugsweise kann das gasdichte Anliegen beispielsweise durch den vom Gehäuse bereitgestellten Druck, d. h. durch Crimpen, erreicht werden. Ferner ist auch möglich, dass das gasdichte Anliegen durch Kleben, Spritzgießen oder dergleichen realisiert wird.

In einer vorteilhaften Ausführungsform umgibt der Zwischenkörper die Schallaufnahmefläche des akustischen Sensors in Umfangsrichtung. Dabei kann unter "in Umfangsrichtung umgeben" verstanden werden, dass die Schallaufnahmefläche des akustischen Sensors derart in den Zwischenkörper hineinragt oder einsinkt, dass der Zwischenkörper und die Schallaufnahmefläche des akustischen Sensors gasdicht aneinander anliegen, d. h., dass dazwischen kein Luftspalt vorliegt. Unter "in Umfangsrichtung umgeben" kann auch verstanden werden, dass die Schallaufnahmefläche des akustischen Sensors von dem Zwischenkörper geschlossen ist, d. h. von der externen Umgebung außerhalb des Zwischenkörpers isoliert ist. Dabei kann zwischen der Schallaufnahmefläche des akustischen Sensors und dem Zwischenkörper ein Hohlraum vorliegen, der in Bezug auf die externe Umgebung geschlossen ist.

Gemäß einer bevorzugten Ausführungsform der vorliegenden Erfindung ist der Zwischenkörper als eine planare Struktur mit Sacklöchern ausgebildet, wobei die Tiefe der Sacklöcher kleiner als die Dicke des akustischen Sensors ist. Der akustische Sensor ist jeweils in ein entsprechendes Sackloch eingesetzt, so dass der Zwischenkörper nur abschnittweise, vorzugsweise konvex, an dem Panel gasdicht anliegt. Dadurch wird einerseits sichergestellt, dass kein Luftspalt zwischen der Schallaufnahmefläche des akustischen Sensors und dem Panel besteht; andererseits muss nicht sichergestellt werden, dass der Zwischenkörper vollflächig im gasdichten Anliegen an dem Panel bleibt, während hier nur erforderlich ist, dass der Zwischenkörper im entsprechenden Bereichs des Sackloch (d. h. im Bereich der Schallaufnahmefläche des akustischen Sensors) gasdicht an dem Panel anliegt. Dadurch wird auf eine einfache und kostengünstige Weise das gasdichte Anliegen der Schallaufnahmefläche des akustischen Sensors an dem Panel garantiert.

Gemäß einer bevorzugten Ausführungsform der vorliegenden Erfindung ist der Zwischenkörper als eine planare Struktur mit Sacklöchern ausgebildet, wobei die Tiefe der Sacklöcher größer als die Dicke des akustischen Sensors ist. Der akustische Sensor ist jeweils in einen entsprechenden Sacklochzwischenkörper eingesetzt, so dass zwischen der Schallaufnahmefläche des akustischen Sensors und dem Panel nur ein geschlossener Hohlraum vorliegt. Weil hier ein Luftspalt zwischen der Schallaufnahmefläche des akustischen Sensors und dem Panel vorliegt, wird vermieden, dass die Schallaufnahmefläche des akustischen Sensors aufgrund eines kräftigen Drückens oder einer Kollision während des Systembetriebs gepresst wird, wodurch der akustische Sensor geschützt und seine Lebensdauer verlängert ist.

Ferner ist der Zwischenkörper vorzugsweise durch Spritzgießen mit der Leiterplatte und/oder dem Panel verbunden. Vorzugsweise wird der Zwischenkörper durch Niederdruckspritzgießen auf die Leiterplatte spritzgegossen, wodurch die Leiterplatte (einschließlich des auf der Leiterplatte angeordneten akustischen Sensors) einstückig mit dem Zwischenkörper ausgebildet ist. Somit ist der Luftspalt zwischen der Schallaufnahmefläche des akustischen Sensors und dem Zwischenkörper beseitigt. Auf ähnlicher Weise kann der Zwischenkörper einstückig mit dem Panel ausgebildet sein und somit der Luftspalt zwischen dem Zwischenkörper und dem Panel in einem einfachen Prozessschritt effektiv beseitigt werden.

Besonders vorteilhaft ist der Zwischenkörper durch Verkleben, insbesondere mittels einer Klebschicht (z. B. eines doppelseitigen Klebebands), mit der Leiterplatte und/oder den Panel verbunden. Zwischen dem Zwischenkörper und der Leiterplatte und/oder dem Panel kann durch Verkleben weiter abgedichtet werden, wodurch sichergestellt wird, dass kein mit der externen Umgebung kommunizierender Luftspalt zwischen der Schallaufnahmefläche des akustischen Sensors und dem Panel vorliegt.

In einer vorteilhaften Alternative ist der Zwischenkörper aus einem elastischen Material, bevorzugt aus einem geschlossenzelligen Schaumstoff, und besonders bevorzugt aus Silikagel oder Schaum hergestellt. Auch andere elastische Materialien sind denkbar, die zum Lösen der Aufgabe der vorliegenden Erfindung geeignet sind.

Ferner liegt die Shore-Härte des Zwischenkörpers zwischen 50 und 110, bevorzugt zwischen 70 und 90, und besonders bevorzugt zwischen 75 und 85. Sowohl zu weiche als auch zu harte Materialien der Zwischenkörper können die Systemleistung beeinträchtigen. Wenn das Material des Zwischenkörpers zu weich ist, kann die Schallwelle, die durch Anklopfen bzw. Antippen des Berührungsbereichs erzeugt ist, vom Zwischenkörper aufgenommen werden, so dass der akustisch Sensor das Signal der Schallwelle nicht empfangen kann oder das empfangene Signal der Schallwelle zu klein ist, als dass die Steuereinrichtung eine genaue Bestimmung vornehmen könnte. Wenn das Material des Zwischenkörpers zu hart ist, kann jedoch die Schallwelle, die durch Anklopfen bzw. Antippen des Berührungsbereichs erzeugt ist, in dem Zwischenkörper verbleiben, was das Auswerten der Steuereinrichtung erschwert und sogar zu einer falschen Bestimmung der Steuereinrichtung führen kann. Die genannte Härte ermöglicht einerseits eine effiziente Übertragung des Signals der Schallwelle an den akustischen Sensor und andererseits eine Dämpfung des Signals der Schallwelle über einen geeigneten Zeitraum. Der "geeignete Zeitraum" ist auf die Steuereinrichtung gerichtet, damit die Steuereinrichtung das empfangene Signal der Schallwelle weiterhin effizient auswerten kann.

In einer weiteren vorteilhaften Ausgestaltung ist die Steuereinrichtung auf der Leiterplatte vorgesehen. Selbstverständlich ist auch möglich, dass die Steuereinrichtung von der Leiterplatte getrennt ist, und die Steuereinrichtung beispielsweise auf einer weiteren Leiterplatte oder direkt im Gehäuse angeordnet ist. Der akustische Sensor kann beispielsweise verdrahtet und/oder drahtlos mit der Steuereinrichtung kommunizieren.

Besonders vorteilhaft ist/sind ein oder mehrere akustische Hilfssensoren um den dem entsprechenden Berührungsbereich zugeordneten akustischen Sensor angeordnet, um die Zuverlässigkeit des Systems zu verbessern. Alternativ ist es möglich, dass der akustische Sensor selbst auch als akustischer Hilfssensor für andere akustische Sensoren verwendbar ist. Vorzugweise kann die Steuereinrichtung abhängig von den Amplitudengrößen und/oder zeitlicher Abfolge und/oder Phasen und/oder Dämpfungseigenschaften der Signale aus dem akustischen Sensor und den akustischen Hilfssensoren die Positionierungsgenauigkeit der Berührungsbetätigung verbessern. Durch Berücksichtigen der Signale aus den akustischen Sensoren, der Signale aus den akustischen Hilfssensoren sowie der charakteristischen Parameter, die den entsprechenden akustischen Sensoren zugeordnet sind, kann der Störfaktor weiter gut eliminiert, die Positionierungsgenauigkeit der Berührungsbetätigung erhöht und somit die Systemleistung verbessert werden. Falls beispielsweise der Schall von dem Haushaltsgerät selbst stammt, werden alle Sensoren (akustische Sensoren und akustische Hilfssensoren) ähnliche Signale erhalten, die von der Steuereinrichtung auf der Ebene des Algorithmus effektiv eliminiert werden können. Auf ähnliche Weise ist möglich, Fehlfunktionen des Systems, die durch Fehlbedienungen verursacht werden, z. B. Schallwellen, die durch unbeabsichtigte Berührungen von Nicht-Berührungsbereichen verursacht werden, effektiv zu eliminieren.

Besonders vorteilhaft kann das Panel aus Metall, Kunststoff, Glas oder Holz bestehen. Im Vergleich zu kapazitiven Touch-Panels, bei denen nur nicht-leitfähige Materialien ausgewählt werden können, haben Touch-Touch-Panels einen breiteren Anwendungsbereich und reichere Auswahl bezüglich der Materialien für Panels. Im Vergleich zu piezoelektrischen Touch-Panels, bei denen das Vorsehen einer dünnen piezoelektrische Materialschicht erforderlich ist, weisen akustische Touch-Panels weniger Herstellungsschwierigkeiten und somit geringere Herstellungskosten auf. Vorteilhafter Weise ist der akustische Sensor ein Mikrofon, vorzugsweise ein mikroelektromechanisches System-Mikrofon (MEMS-Mikrofon). Selbstverständlich sind auch andere Arten von Sensoren zum Messen von Schallwellen denkbar.

In einer vorteilhaften Alternative ist der Zwischenkörper durch Crimpen, Spritzgießen oder Verkleben unterhalb des Panels und oberhalb der Leiterplatte vorgesehen, wobei die Steuereinrichtung mit dem akustischen Sensor auf der Leiterplatte kommuniziert, wobei das Gehäuse und das Panel zusammen den Zwischenkörper, die Leiterplatte sowie die Steuereinrichtung umgeben, und das Gehäuse den Druck zum Sicherstellen des Zusammendrückens des Zwischenkörpers und der Schallaufnahmefläche des akustischen Sensors bereitstellt.

Gemäß einem weiteren Aspekt betrifft die vorliegende Erfindung noch ein Haushaltsgerät mit einem oben genannten akustischen Berührungssystem. Alternativ kann das Haushaltsgerät beispielsweise eine Waschmaschine, eine Geschirrspülmaschine, ein Kühlschrank, eine Klimaanlage, ein Induktionsherd oder ein Gasherd usw. sein.

### Kurze Beschreibung der Figuren

Die hier erläuterten Zeichnungen sollen ein weiteres Verständnis der Erfindung bereitstellen. Die schematischen Darstellungen der vorliegenden Erfindung und deren Beschreibung dienen lediglich der Erläuterung der vorliegenden Erfindung und beschränken die vorliegende Erfindung nicht.
Fig. 1a zeigt eine schematische Draufsicht eines Touch-Panels;
Fig. 1b zeigt eine schematische Schnittansicht eines akustischen Berührungssystems;
Fig. 2 zeigt ein Signalausgabediagramm eines akustischen Sensors;
Fig. 3 zeigt eine beispielhafte Anordnungsansicht eines akustischen Sensors zusammen mit einem akustischen Hilfssensor;
Fig. 4 zeigt eine erste Ausführungsform eines akustischen Berührungssystems;
Fig. 5 zeigt eine zweite Ausführungsform eines akustischen Berührungssystems;
Fig. 6 zeigt eine dritte Ausführungsform eines akustischen Berührungssystems;
Fig. 7 zeigt eine vierte Ausführungsform eines akustischen Berührungssystems;
Fig. 8 zeigt eine fünfte Ausführungsform eines akustischen Berührungssystems;
Fig. 9 zeigt eine sechste Ausführungsform eines akustischen Berührungssystems; und
Fig. 10 zeigt eine siebte Ausführungsform eines akustischen Berührungssystems.

### Ausführliche Ausführungsformen

Die Ausführungsformen der vorliegenden Erfindung werden nachfolgend anhand der Zeichnungen beispielhaft näher erläutert. Die ausführlichen Ausführungsformen dienen zum näheren Beschreiben des Konzepts der vorliegenden Erfindung, der zu lösenden technischen Aufgabe, der die technischen Ausgestaltungen bildenden technischen Merkmale sowie der damit einhergehenden technischen Wirkungen. Es wird angemerkt, dass die daraus abgeleiteten einzelnen Merkmale nicht auf die einzelnen Ausführungsformen beschränkt sind, sondern mit den einzelnen Merkmalen weiterer Beschreibung und/oder weiterer Ausführungsformen zusammenhängen und/oder kombiniert werden können. Die einzelnen Details in den Figuren sollen lediglich illustrativ und nicht einschränkend sein.

Das akustische Berührungssystem erfasst mittels eines oder mehrerer akustischen Sensoren hauptsächlich die Schallwelle, die durch Anklopfen bzw. Antippen des Berührungspanels erzeugt wird, und positioniert aufgrund der erfassten Schallwelle die Position des Anklopfens bzw. Antippens genau. Daher ist das akustische Berührungssystem gemäß der vorliegenden Erfindung basierend auf dem Grundprinzip des akustischen Berührungssystems ein weit verbreitetes und zuverlässiges Berührungssystem. Insbesondere ist das akustische Berührungssystem für eine Vielzahl von berührenden Objekttypen geeignet, kann Panels unterschiedlicher Materialtypen verwenden und ist durch Feuchtigkeit und Pressdruck nicht beeinflussbar.

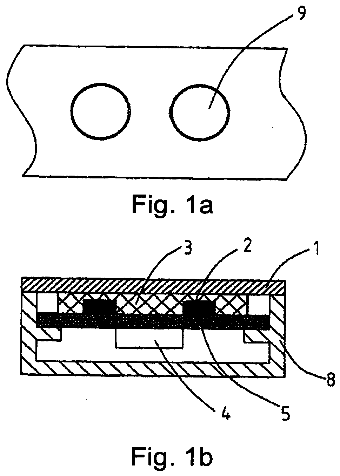

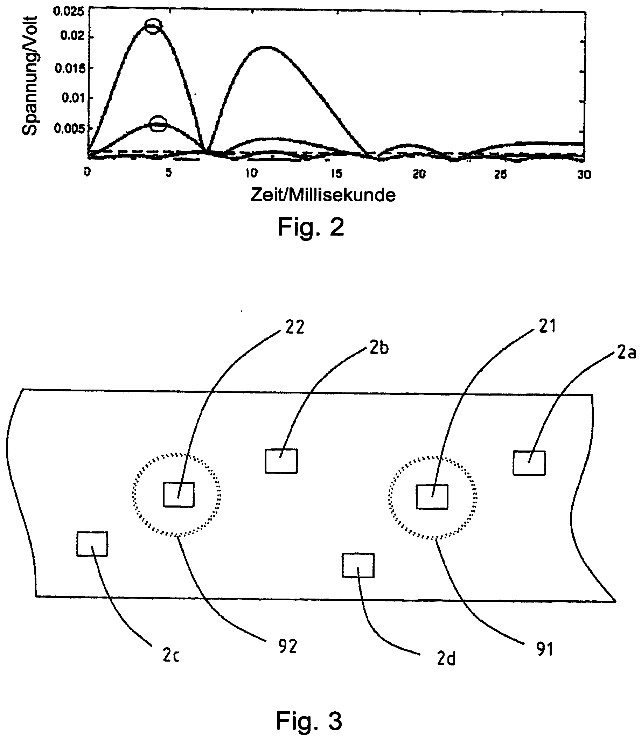

Im Folgenden ist das akustische Berührungssystem anhand von Fig. 1a, 1b und 2 detailliert beschrieben.

Fig. 1a zeigt eine schematische Ansicht eines Touch-Panels. Wie in Fig. 1a gezeigt, liegen auf dem Touch-Panel 1 beispielhaft zwei Berührungsbereiche 9 vor. Aufgrund des Grundprinzips des akustischen Berührungssystems sind dabei verschiedene Paneltypen verwendbar, beispielsweise Panels aus Metall, Kunststoff, Glass oder Holz. Dabei kann jeder Berührungsbereich eine Funktion repräsentieren, wobei beispielsweise die jeweilige Funktion durch Anklopfen oder Antippen des Berührungsbereichs aktiviert werden kann. Es wird angemerkt, dass sich das berührende Objekt auf verschiedene Arten von Objekten beziehen kann, beispielsweise einen menschlichen Körperteil wie einen Finger (einschließlich eines Fingers in einem Kunststoffhandschuh); nichtleitende Objekte, wie Kunststoffobjekte; oder leitende Objekte, wie Metallstäbe usw. Selbstverständlich können auf dem Touch-Panel 1 noch mehrere Berührungsbereiche 9 (am Beispiel einer Waschmaschine kann für verschiedene Funktionen wie Schnellwaschen, Spülen oder Feinwaschen jeweils ein Berührungsbereich 9 vorgesehen werden), die verschiedene Funktionen repräsentieren, vorgesehen werden.

Fig. 1b zeigt eine schematische Schnittansicht des akustischen Berührungssystems. Wie in Fig. 1b gezeigt, umfasst das akustische Berührungssystem beispielhaft ein Panel 1, einen akustischen Sensor 2, eine Steuereinrichtung 4, einen Zwischenkörper 3 und ein Gehäuse 8. Dabei ist das akustische Berührungssystem beispielhaft mit zwei akustische Sensoren 2 versehen. Dabei sind die akustischen Sensoren 2 jeweils einem entsprechenden Berührungsbereich 9 zugeordnet. Dabei ist die dem Benutzer zugewandte Seite des Panels als die Vorderseite des Bedienfelds definiert. Der akustische Sensor 2 ist auf der Rückseite des Panels 1, vorzugsweise mittig unterhalb des entsprechenden Berührungsbereichs 9 angeordnet. Der akustische Sensor 2 ist vorzugsweise als MEMS-Mikrofon ausgebildet ist. Das MEMS-Mikrofon ist ein Mikrofon, das basierend auf der MEMS-Technik hergestellt wird und verbesserte Rauschunterdrückungsleistung sowie gute Unterdrückungsfähigkeit für Funkfrequenz (RF) und elektromagnetische Interferenz (EMI) aufweist. Ferner ist aus Fig. 1b ersichtlich, dass beispielhaft zwei MEMS-Mikrofone auf der Leiterplatte 5 angeordnet sind. Gleichzeitig ist die Steuereinrichtung 4 auch beispielhaft auf der Leiterplatte 5 angeordnet. Es wird darauf hingewiesen, dass die "Steuereinrichtung" im Umfang der vorliegenden Anmeldung ein Steuergerät, das einen Speicher (z. B. RAM, ROM, EPROM, EEPROM, Flash-Speicher oder anderer Festkörperspeicher), einen Prozessor (z. B. CPU, DSP usw.) und eine Eingabe-/Ausgabeeinrichtung umfasst, oder eine Steuerschaltung, die aus diskreter analoger Elektronik und/oder digitaler Elektronik besteht, oder sogar eine anwendungsspezifische integrierte Schaltung (ASIC) sein kann. Es ist auch denkbar, verschiedene andere Arten von Vorrichtungen auf der Leiterplatte 5 zu integrieren. Dabei dient einerseits die Leiterplatte 5 dazu, die einzelnen Vorrichtungen zu integrieren, wodurch die Verdrahtung vereinfacht und der Platzbedarf reduziert wird; andererseits dient sie auch als Abstützelement für die einzelnen Vorrichtungen.

Ferner ist aus Fig. 1b ersichtlich, dass der Zwischenkörper zwischen dem Touch-Panel 1 und der Leiterplatte 5 angeordnet ist. Die Funktion des Zwischenkörpers 3 besteht hauptsächlich darin, die Schallaufnahmefläche des akustischen Sensors 2 von der externen Umgebung gasdicht zu isolieren. Es wird angemerkt, dass die gasdichte Isolierung der Schallaufnahmefläche des akustischen Sensors 2 von der externen Umgebung bedeutet, dass der Zwischenkörper 3 so ausgebildet ist, dass zwischen der Schallaufnahmefläche des akustischen Sensors 2 und dem Panel kein mit der externen Umgebung kommunizierender Luftspalt besteht. Dadurch wird sichergestellt, dass ein Geräusch der externen Umgebung nicht über den Luftspalt direkt auf die Schallaufnahmefläche des akustischen Sensors 2 übertragen wird und somit die Störung des akustischen Sensors vermieden wird. Durch die gasdichte Isolierung der Schallaufnahmefläche des akustischen Sensors 2 gegenüber der externen Umgebung werden jegliche Störfaktoren (z. B. Straßengeräusche) in der atmosphärischen Umgebung bzw. dem Schallfeld ausgeschlossen, in der bzw. dem sich das gesamte akustische Berührungssystem befindet. Dabei kann der Zwischenkörper aus Silikagel oder Schaum hergestellt sein. Ferner liegt die Shore-Härte des Zwischenkörpers zwischen 50 und 110, bevorzugt zwischen 70 und 90, und besonders bevorzugt zwischen 75 und 85. Sowohl zu weiche als auch zu harte Materialien der Zwischenkörper können die Systemleistung beeinträchtigen. Wenn das Material des Zwischenkörpers zu weich ist, kann die Schallwelle, die durch Anklopfen bzw. Antippen des Berührungsbereichs erzeugt wird, vom Zwischenkörper absorbiert werden, so dass der akustisch Sensor das Signal der Schallwelle nicht empfangen kann oder das empfangene Signal der Schallwelle zu klein ist, als dass die Steuereinrichtung eine genaue Bestimmung vornehmen könnte. Wenn das Material des Zwischenkörpers zu hart ist, kann jedoch die Schallwelle, die durch Anklopfen bzw. Antippen des Berührungsbereichs erzeugt ist, in dem Zwischenkörper verbleiben, was das Auswerten der Steuereinrichtung erschweren kann und sogar zu einer falschen Bestimmung der Steuereinrichtung führen kann. Die angegebene Härte ermöglicht einerseits eine effiziente Übertragung des Signals der Schallwelle an den akustischen Sensor und andererseits eine Dämpfung des Signals der Schallwelle über einen geeigneten Zeitraum. Der "geeignete Zeitraum" ist auf die Steuereinrichtung gerichtet. Die geeignete Härte wird für unterschiedliche Steuerungsvorrichtung ausgewählt, damit die Steuereinrichtung das empfangene Signal der Schallwelle weiterhin effizient auswerten kann.

Ferner ist aus Fig. 1b ersichtlich, dass das akustische Berührungssystem ferner mit einem U-förmigen Gehäuse 8 versehen ist, das zur Aufnahme des Zwischenkörpers 3, der Leiterplatte 5 und der Steuereinrichtung 4 ausgebildet ist, und das zusammen mit dem Touch-Panel 1 das gesamte System schließt. Aus Fig. 1b ist ersichtlich, dass das Gehäuse 8 mit zwei Schultern ausgebildet ist, auf denen die Leiterplatte 5 angeordnet ist. Bei der Montage sind das Gehäuse 8 und das Touch-Panel 1 gegeneinander zusammengedrückt, wodurch ein Druck bereitgestellt wird, um ein gegenseitiges Zusammendrücken des Zwischenkörpers 3 mit der Leiterplatte 5 oder mit der Schallaufnahmefläche des akustischen Sensors 2 sicherzustellen. Dadurch wird eine gasdichte Isolierung von der externen Umgebung sicherstellt (d. h. es besteht kein kommunizierender Luftspalt).

Der Betriebsprozess des akustischen Berührungssystems wird nachfolgend beispielhaft erläutert. Um beispielsweise die durch den Berührungsbereich 9 auf der linken Seite der Fig. 1a dargestellte Funktion (z. B. die Spülfunktion) auszulösen, kann der Benutzer den Berührungsbereich 9 auf der linken Seite der Fig. 1a auf dem Touch-Panel 1 anklopfen bzw. antippen. Dadurch werden Schallwellen an Positionen erzeugt, an denen das Anklopfen bzw. Antippen erfolgt. Somit werden die Schallwellen von dem Touch-Panel 1 über den Zwischenkörper 3 direkt zu der Schallaufnahmefläche des akustischen Sensors 2 auf der linken Seite der Fig. 1b geleitet. Im Fall des vorliegenden Ausführungsbeispiels gibt es keinen Luftspalt in dem Schallwellenleitungspfad. Hierbei erfasst der akustische Sensor des Berührungsbereich 9 auf der linken Seite in Fig. 1a zunächst die durch Anklopfen bzw. Antippen erzeugte Schallwelle. Der akustische Sensor überträgt dann die erfasste Schallwelle in Form von elektrischen Signalen verdrahtet oder drahtlos an die Steuereinrichtung 4. Abhängig von den empfangenen elektrischen Signalen bestimmt die Steuereinrichtung 4, dass der Benutzer den Berührungsbereich 9 auf der linken Seite in Fig. 1a betätigt, wodurch die vom Berührungsbereich repräsentierten Funktionen (z. B. die Spülfunktion) aktiviert werden können.

Dabei kann der akustische Sensor 2 auf der rechten Seite in Fig. 1b die Schallwelle empfangen und die erfasste Schallwelle in Form von elektrischen Signalen verdrahtet oder drahtlos an die Steuereinrichtung 4 übertragen. Die Steuereinrichtung kann abhängig von zeitlicher Abfolge der von den jeweiligen akustischen Sensoren empfangenen Signale der Schallwellen und/oder den Amplitudengrößen der empfangenen Signale der Schallwellen und/oder Phasen der Signale der Schallwellen und/oder Dämpfungseigenschaften der Signale der Schallwellen den angeklopften bzw. angetippten Berührungsbereich 9 bestimmen.

Zur Erläuterung, ist das Signalausgabediagramm des jeweiligen akustischen Sensors beispielhaft in Fig. 2 gezeigt. In der Figur ist die Ordinate die Ausgangsspannung des akustischen Sensors (in Volt) und die Abszisse die Zeit (in Millisekunden). Wie aus Fig. 2 ersichtlich ist, klingen die Schallwellen mit der Zeit ab. Der Sensor, der zuerst die Schallwelle erfasst, gibt ein maximales Spannungssignal aus. Beispielsweise beträgt der Spitzenwert des Spannungssignals im Fall des vorliegenden Ausführungsbeispiels etwa 0,022 Volt. Der Sensor, der später die Schallwelle erfasst, gibt ein kleineres Spannungssignal aus. Beispielsweise beträgt der Spitzenwert des Spannungssignals im Fall des vorliegenden Ausführungsbeispiels etwa 0,005 Volt. Somit kann die Steuereinrichtung 4 basierend auf der Amplitude des Spannungssignals einen Berührungsbereich 9 bestimmen, wo das Anklopfen bzw. Antippen erfolgt, wodurch die entsprechende Funktion ausgelöst wird (z. B. Starten des Spülmodus). Vorteilhafterweise können zusätzlich zu der Amplitudengröße des Signals der Schallwelle eine Vielzahl von variablen Faktoren, z. B. die zeitliche Abfolge, die Phase, die Dämpfungseigenschaften des Signals der Schallwelle, in Betracht gezogen werden. Zum Beispiel werden im Fall des vorliegenden Ausführungsbeispiels die Amplitudengröße, die zeitliche Abfolge, die Phasen und die Dämpfungseigenschaften der empfangenen Signale der jeweiligen akustischen Sensoren 2 jeweils in der Steuereinrichtung aufgezeichnet. Dann kann die Steuereinrichtung dementsprechend einen Algorithmus zum Filtern und Beurteilen (zum Beispiel durch einen Fuzzy-Steueralgorithmus) zum Verbessern der Positionierungsgenauigkeit der Berührungsbetätigung und zum besseren Bestimmen des angeklopften bzw. angetippten Berührungsbereichs aufweisen.

Um die Betriebsleistung des gesamten Systems weiter zu verbessern, kann/können zusätzlich ein oder mehrere akustische Hilfssensoren für jeden Berührungsbereich vorgesehen sein. Der Grund liegt darin, dass beispielsweise Vibrationen einer Einrichtung selbst, an der das akustische Berührungssystem angebracht ist, oder unbeabsichtigtes oder versehentliches Anklopfen bzw. Antippen außerhalb des Berührungsbereichs die entsprechende Funktion fälschlicherweise auslösen könnten.

Fig. 3 zeigt eine beispielhafte Anordnungsansicht eines akustischen Sensors zusammen mit einem akustischen Hilfssensor. Hierbei sind akustische Hilfssensoren 2a, 2b, 2c, 2d um die den jeweiligen Berührungsbereichen 91, 92 zugeordneten akustischen Sensoren 21, 22 angeordnet. Die Steuereinrichtung kann beispielsweise die Störungen basierend auf der Amplitude und/oder Phase der Signale aus den akustischen Sensoren 21, 22 und den akustischen Hilfssensoren 2a, 2b, 2c, 2d ausschließen. Wenn die Einrichtung selbst vibriert, erhalten alle Sensoren (d. h. die Sensoren zusammen mit den akustischen Hilfssensoren) ein ähnliches Signal. Wenn beispielsweise ein Finger den entsprechenden Berührungsbereich 91 anklopft oder antippt, erhält jedoch der entsprechende akustische Sensor 21 das stärkste Signal. Die Störung, die durch die Vibration der Einrichtung selbst verursacht wird, kann basierend auf dem Unterschied, der in Bezug auf Fig. 2 erläutert ist, ausgeschlossen werden. Wenn das Anklopfen bzw. Antippen außerhalb des Berührungsbereichs erfolgt, beispielsweise wenn das Anklopfen bzw. Antippen in der Nähe des akustischen Hilfssensors 2a erfolgt, werden analog diese Störungen ausgeschlossen, weil der akustische Sensor 21 ein Signal aufweist, das relativ groß, aber kleiner als das Signal des akustischen Hilfssensors 2a ist. Es muss darauf hingewiesen werden, dass die obige Situation nur eine beispielhafte Erläuterung darstellt, und andere unterschiedliche Verbesserungen auf der Ebene des Algorithmus auch denkbar sind, um verschiedene Störfaktoren besser und effizienter auszuschließen.

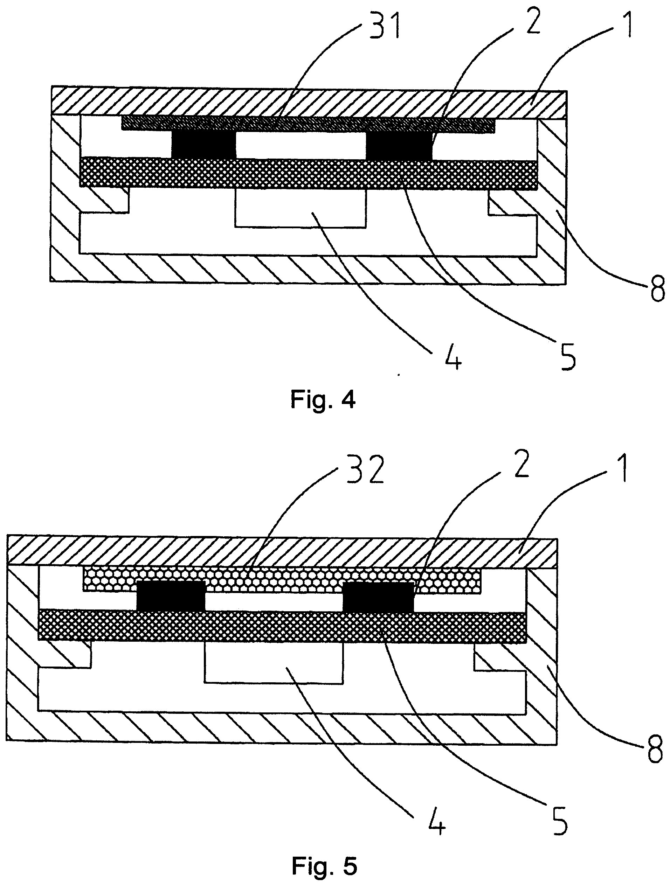

Fig. 4 zeigt eine erste Ausführungsform eines vorgeschlagenen akustischen Berührungssystems. Wie in Fig. 4 gezeigt, umfasst das akustische Berührungssystem beispielhaft ein Panel 1, eine Leiterplatte 5, eine Steuereinrichtung 4, einen Zwischenkörper 31 und ein Gehäuse 8. Auf der Leiterplatte 5 sind beispielhaft zwei akustische Sensoren 2 vorgesehen. Die Steuereinrichtung 4 ist dazu vorgesehen, Signale aus den akustischen Sensoren 2 zu empfangen und weiterhin auszuwerten. Dabei ist der Zwischenkörper 31 aus einem Silikonelement mit einer Shore-Härte zwischen 50 und 110, vorzugsweise zwischen 70 und 90, besonders bevorzugt zwischen 75 und 85, hergestellt. Wie aus Fig. 4 ersichtlich ist, kann die Schallaufnahmefläche des akustischen Sensors aufgrund der Materialeigenschaften des Silikonelements und des vom Gehäuse bereitgestellten Drucks gasdicht an das Silikonelement anliegen, so dass kein Luftspalt zwischen dem Silikonelement und der Schallaufnahmefläche des akustischen Sensors vorhanden ist. Vorzugsweise kann das Silikonelement mit der Leiterplatte 5 und/oder dem Panel 1 durch Verkleben, insbesondere mittels einer Klebeschicht, verbunden sein. In diesem Ausführungsbeispiel ist die Schallwelle von dem Touch-Panel über das Silikonelement zu dem akustischen Sensor geleitet. Vorzugsweise ist die Schallwelle von dem Touch-Panel über die Klebeschicht und dann über das Silikonelement zu dem akustischen Sensor geleitet.

Fig. 5 zeigt eine zweite Ausführungsform eines akustischen Berührungssystems. Wie in Fig. 5 gezeigt, umfasst das akustische Berührungssystem beispielhaft ein Panel 1, eine Leiterplatte 5, eine Steuereinrichtung 4, einen Zwischenkörper 32 und ein Gehäuse 8. Auf der Leiterplatte 5 sind beispielhaft zwei akustische Sensoren 2 vorgesehen. Die Steuereinrichtung 4 ist dazu vorgesehen, Signale aus den akustischen Sensoren 2 zu empfangen und weiterhin auszuwerten. Dabei ist der Zwischenkörper 32 aus einem Schaum mit einer Shore-Härte zwischen 50 und 110, vorzugsweise zwischen 70 und 90, besonders bevorzugt zwischen 75 und 85, hergestellt. Selbstverständlich sind auch andere geschlossenzellige Schaumstoffe denkbar, z. B. Steinwolle, Mineralwolle und dergleichen. Wie aus Fig. 5 ersichtlich ist, kann die Schallaufnahmefläche des akustischen Sensors aufgrund der Materialeigenschaften des Schaums und des von dem Gehäuse bereitgestellten Drucks in den Schaum hineinragen oder einsinken, so dass der Schaum und die Schallaufnahmefläche des akustischen Sensor aneinander gasdicht anliegen (d. h. es gibt keinen Luftspalt). Vorzugsweise kann der Schaum mit der Leiterplatte 5 und/oder dem Panel 1 durch Verkleben, insbesondere mittels einer Klebeschicht, verbunden sein. In diesem Ausführungsbeispiel ist die Schallwelle von dem Touch-Panel über den Schaum zu dem akustischen Sensor geleitet. Vorzugsweise ist die Schallwelle von dem Touch-Panel über die Klebeschicht und dann über den Schaum zu dem akustischen Sensor geleitet.

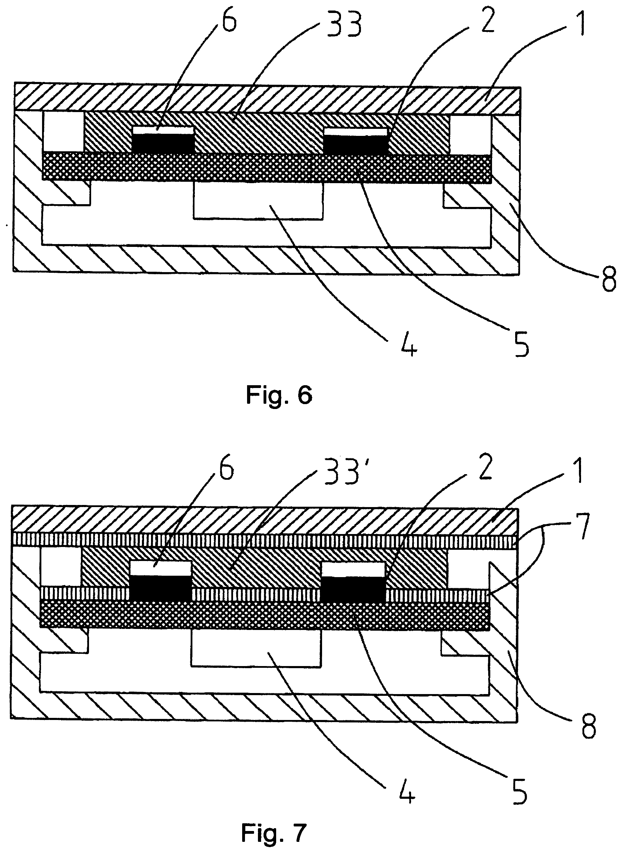

Fig. 6 zeigt eine dritte Ausführungsform eines akustischen Berührungssystems. Wie in Fig. 6 gezeigt, umfasst das akustische Berührungssystem beispielhaft ein Panel 1, eine Leiterplatte 5, eine Steuereinrichtung 4, einen Zwischenkörper 33 und ein Gehäuse 8. Auf der Leiterplatte 5 sind beispielhaft zwei akustische Sensoren 2 vorgesehen. Die Steuereinrichtung 4 ist dazu vorgesehen, Signale aus den akustischen Sensoren 2 zu empfangen und weiterhin auszuwerten. Dabei ist der Zwischenkörper 33 aus einem Silikonelement hergestellt, das durch Niederdruckspritzgießen zu einer planaren Struktur mit Sacklöchern geformt wird. Wie aus Fig. 6 ersichtlich ist, ist die Tiefe der Sacklöcher größer als die Dicke der akustischen Sensoren 2. Die akustischen Sensoren 2 sind jeweils in die Zwischenkörper 33 der jeweiligen Sacklöcher eingesetzt, so dass nur ein geschlossener Hohlraum 6 zwischen der Schallaufnahmefläche des akustischen Sensors 2 und dem Panel 1 vorliegt. Dabei ist das Vorliegen des Hohlraums 6 vorteilhaft, weil vermieden werden kann, dass die Schallaufnahmefläche des akustischen Sensors während des Systembetriebs gepresst wird, womit der akustische Sensor geschützt wird und seine Lebensdauer verlängert ist. In diesem Ausführungsbeispiel ist die Schallwelle von dem Touch-Panel über das Silikonelement und dann über den Hohlraum zu dem akustischen Sensor geleitet.

Fig. 7 zeigt eine vierte Ausführungsform eines akustischen Berührungssystems. Zusätzlich zum dritten Ausführungsbeispiel des akustischen Berührungssystems sind die Zwischenkörper 33' des akustischen Berührungssystems in Fig. 7 jeweils mithilfe von zwei Klebeschichten 7 mit der Leiterplatte 5 und dem Panel 1 verbunden, wodurch die Gasdichtheit weiter verbessert ist. In diesem Ausführungsbeispiel ist die Schallwelle von dem Touch-Panel über die Klebeschicht, dann über das Silikonelement und weiter über den Hohlraum zu dem akustischen Sensor geleitet.

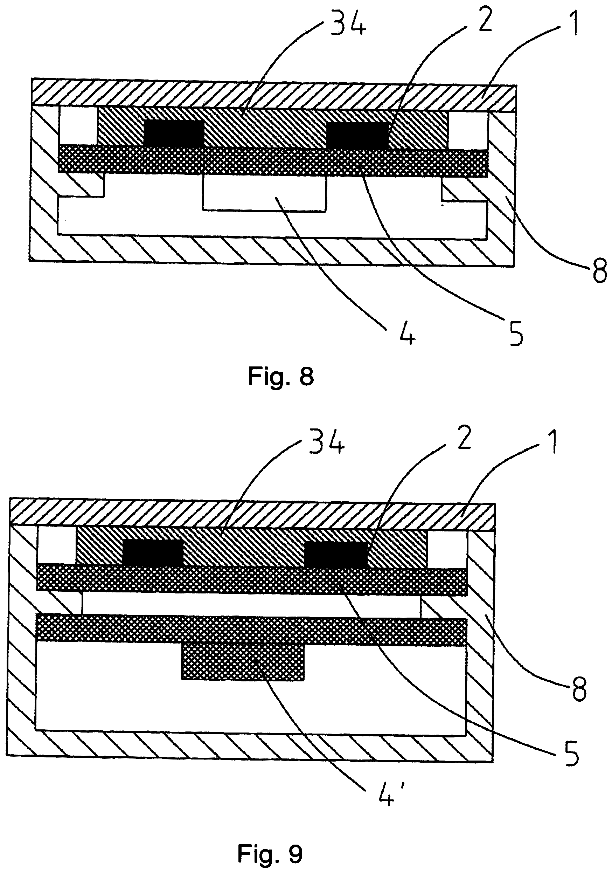

Fig. 8 zeigt eine fünfte Ausführungsform eines akustischen Berührungssystems. Wie in Fig. 8 gezeigt, umfasst das akustische Berührungssystem beispielhaft ein Panel 1, eine Leiterplatte 5, eine Steuereinrichtung 4, einen Zwischenkörper 34 und ein Gehäuse 8. Auf der Leiterplatte 5 sind beispielhaft zwei akustische Sensoren 2 vorgesehen. Die Steuereinrichtung 4 ist dazu vorgesehen, Signale aus den akustischen Sensoren 2 zu empfangen und weiterhin auszuwerten. Dabei ist der Zwischenkörper 34 aus einem Silikonelement hergestellt, das durch Niederdruckspritzgießen auf die Leiterplatte spritzgegossen ist, wodurch die Leiterplatte (einschließlich des auf der Leiterplatte angeordneten akustischen Sensors) einstückig mit dem Silikonelement ausgebildet und somit der Luftspalt zwischen der Schallaufnahmefläche des akustischen Sensors und dem Zwischenkörper beseitigt ist. Auf ähnliche Weise kann das Silikonelement einstückig mit dem Panel ausgebildet sein. Somit ist der Luftspalt zwischen dem Zwischenkörper und dem Panel beseitigt. Es ist auch möglich, das Silikonelement durch Crimpen oder Verkleben mit dem Panel zu verbinden. In diesem Ausführungsbeispiel ist die Schallwelle von dem Touch-Panel über das Silikonelement zu dem akustischen Sensor geleitet.

Fig. 9 zeigt eine sechste Ausführungsform eines akustischen Berührungssystems. Wie in Fig. 9 gezeigt, umfasst das akustische Berührungssystem beispielhaft ein Panel 1, eine Leiterplatte 5, eine Steuereinrichtung 4', einen Zwischenkörper 34 und ein Gehäuse 8. Auf der Leiterplatte 5 sind beispielhaft zwei akustische Sensoren 2 vorgesehen. Die Steuereinrichtung 4' ist dazu vorgesehen, Signale aus den akustischen Sensoren 2 zu empfangen und weiterhin auszuwerten. Wie aus Figur 9 ersichtlich ist, ist die Steuereinrichtung 4' von der Leiterplatte 5 getrennt. Dabei ist die Steuereinrichtung 4' beispielhaft auf einer weiteren Leiterplatte vorgesehen. Dabei kann der akustische Sensor 2 verdrahtet oder drahtlos mit der Steuereinrichtung 4' kommunizieren.

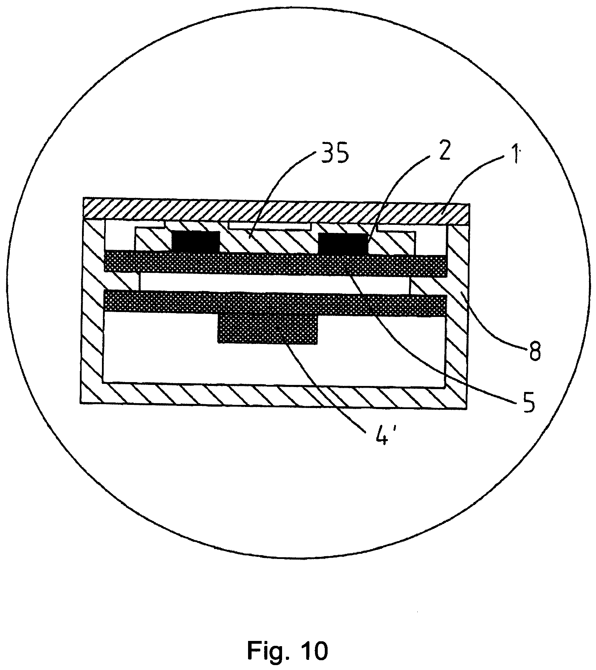

Fig. 10 zeigt eine siebte Ausführungsform eines akustischen Berührungssystems. Wie in Fig. 10 gezeigt, umfasst das akustische Berührungssystem beispielhaft ein Panel 1, eine Leiterplatte 5, eine Steuereinrichtung 4', einen Zwischenkörper 35 und ein Gehäuse 8. Auf der Leiterplatte 5 sind beispielhaft zwei akustische Sensoren 2 vorgesehen. Die Steuereinrichtung 4' ist dazu vorgesehen, Signale aus den akustischen Sensoren 2 zu empfangen und weiterhin auszuwerten. Dabei ist der Zwischenkörper 35 aus einem Silikonelement hergestellt, das durch Niederdruckspritzgießen zu einer planaren Struktur mit Sacklöchern geformt wird. Wie aus Fig. 10 ersichtlich ist, ist die Tiefe der Sacklöcher kleiner als die Dicke der akustischen Sensoren 2, und sind die akustischen Sensoren 2 jeweils in das jeweilige Sackloch eingesetzt, so dass das Silikonelement nur abschnittweise, vorzugsweise konvex, an dem Panel 1 gasdicht anliegt. Es wird darauf hingewiesen werden, dass das vollflächige gasdichte Anliegen des Silikonelements an dem Panel die Herstellung erschwert und somit die Herstellungskosten erhöht. Daher ist besonders vorteilhaft, dass dabei nur ein gasdichtes Anliegen des Silikonelements an dem Panel in einem den Sacklöchern entsprechenden Bereich (d. h., in einem Bereich der Schallaufnahmefläche des akustischen Sensors) realisiert wird. Ferner ist aus Fig. 10 auch ersichtlich, dass die Steuereinrichtung 4' von der Leiterplatte 5 getrennt ist. Dabei ist die Steuereinrichtung 4' beispielhaft auf einer weiteren Leiterplatte vorgesehen. Dabei kann der akustische Sensor 2 verdrahtet oder drahtlos mit der Steuereinrichtung 4' kommunizieren. In diesem Ausführungsbeispiel ist die Schallwelle von dem Touch-Panel über den Silikonelement (genauer gesagt, über den Vorsprung des Silikonelements) zu dem akustischen Sensor geleitet.

Die vorliegende Erfindung ist nicht auf die gezeigten Ausführungsformen beschränkt, sondern umfasst alle technischen Äquivalente, die in den Umfang der beigefügten Ansprüche fallen. Die in der Beschreibung gewählten Positionsangaben, z. B. oben, unten, links, rechts und dergleichen, beziehen sich auf die direkt beschriebenen und dargestellten Figuren und können im Sinne einer Positionsänderung an neue Orte übertragen werden.

## Patentansprüche

1. Akustisches Berührungssystem mit
einem Panel (1) mit einem Berührungsbereich (9, 91, 92) ;
einem akustischen Sensor (2, 22, 23), der jeweils einem entsprechenden Berührungsbereich (9, 91, 92) zugeordnet ist;
einer Steuereinrichtung (4, 4'), die dazu vorgesehen ist, Signale aus dem akustischen Sensor (2, 22, 23) zu empfangen und weiter auszuwerten; und
einem Zwischenkörper (3, 31, 32, 33, 33', 34, 35), der eine Schallaufnahmefläche des akustischen Sensors (2, 22, 23) von externer Umgebung gasdicht isolieren kann.

2. Akustisches Berührungssystem nach Anspruch 1, **dadurch gekennzeichnet, dass** das akustische Berührungssystem ferner eine Leiterplatte (5) umfasst, wobei auf der Leiterplatte (5) der akustische Sensor (2, 22, 23) vorgesehen ist, und wobei zwischen dem Panel (1) und der Leiterplatte (5) der Zwischenkörper (3, 31, 32, 33, 33', 34, 35) vorgesehen ist.

3. Akustisches Berührungssystem nach einem der Ansprüche 1 oder 2, **dadurch gekennzeichnet, dass** weiter ein Gehäuse (8) umfasst ist, das den Zwischenkörper (3, 31, 32, 33, 33', 34, 35), die Leiterplatte (5) und die Steuereinrichtung (4, 4') aufnimmt, und dass das Gehäuse (8) und das Panel (1) so ausgebildet sind, dass der Zwischenkörper (3, 31, 32, 33, 33', 34, 35) und die Leiterplatte (5) gegeneinander zusammengedrückt sind.

4. Akustisches Berührungssystem nach einem der Ansprüche 1 bis 3, **dadurch gekennzeichnet, dass** beim Vorliegen von mehreren akustischen Sensoren (2, 22, 23) der Zwischenkörper (3, 31, 32, 33, 33', 34, 35) so ausgebildet ist, dass die Schallaufnahmeflächen der mehreren akustischen Sensoren voneinander gasdicht isoliert sind.

5. Akustisches Berührungssystem nach einem der Ansprüche 1 bis 4, **dadurch gekennzeichnet, dass** beim Vorliegen von mehreren Zwischenkörpern (3, 31, 32, 33, 33', 34, 35) jeder der Zwischenkörper einem akustischen Sensor (2, 22, 23) zugeordnet ist.

6. Akustisches Berührungssystem nach einem der Ansprüche 1 bis 5, **dadurch gekennzeichnet, dass** der Zwischenkörper (3, 31, 32, 33, 33', 34, 35) die Schallaufnahmefläche des akustischen Sensors (2, 22, 23) in Umfangsrichtung umgibt.

7. Akustisches Berührungssystem nach einem der Ansprüche 1 bis 6, **dadurch gekennzeichnet, dass** der Zwischenkörper (3, 31, 32, 33, 33', 34, 35) gasdicht an der Schallaufnahmefläche des akustischen Sensors (2, 22, 23) anliegt.

8. Akustisches Berührungssystem nach einem der Ansprüche 1 bis 7, **dadurch gekennzeichnet, dass** der Zwischenkörper (3, 31, 32, 33, 33', 34, 35) als eine planare Struktur mit Sacklöchern ausgebildet ist, wobei die Tiefe der Sacklöcher kleiner als die Dicke des akustischen Sensors (2, 22, 23) ist, und dass der akustische Sensor (2, 22, 23) jeweils in ein entsprechendes Sackloch eingesetzt ist, so dass der Zwischenkörper (3, 31, 32, 33, 33', 34, 35) nur abschnittweise, vorzugsweise konvex, an dem Panel (1) gasdicht anliegt.

9. Akustisches Berührungssystem nach einem der Ansprüche 1 bis 8, **dadurch gekennzeichnet, dass** der Zwischenkörper (3, 31, 32, 33, 33', 34, 35) als eine planare Struktur mit Sacklöchern ausgebildet ist, wobei die Tiefe der Sacklöcher größer als die Dicke des akustischen Sensors (2, 22, 23) ist, und dass der akustische Sensor (2, 22, 23) jeweils in ein entsprechendes Sackloch des Zwischenkörpers (3, 31, 32, 33, 33', 34, 35) eingesetzt ist, so dass zwischen der Schallaufnahmefläche des akustischen Sensors (2) und dem Panel (1) nur ein geschlossener Hohlraum (6) vorliegt.

10. Akustisches Berührungssystem nach einem der Ansprüche 1 bis 9, **dadurch gekennzeichnet, dass** der Zwischenkörper (3, 31, 32, 33, 33', 34, 35) durch Spritzgießen mit der Leiterplatte (5) und/oder dem Panel (1) verbunden ist.

11. Akustisches Berührungssystem nach einem der Ansprüche 1 bis 10, **dadurch gekennzeichnet, dass** der Zwischenkörper (3, 31, 32, 33, 33', 34, 35) durch Verkleben, insbesondere mittels einer Klebschicht, mit der Leiterplatte (5) und/oder den Panel (1) verbunden ist.

12. Akustisches Berührungssystem nach einem der vorhergehenden Ansprüche, **dadurch gekennzeichnet, dass** der Zwischenkörper (3, 31, 32, 33, 33', 34, 35) aus einem elastischen Material, bevorzugt aus einem geschlossenzelligen Schaumstoff, und besonders bevorzugt aus Silikagel oder Schaum hergestellt ist.

13. Akustisches Berührungssystem nach einem der vorhergehenden Ansprüche, **dadurch gekennzeichnet, dass** die Shore-Härte des Zwischenkörpers (3, 31, 32, 33, 33', 34, 35) zwischen 50 und 110, bevorzugt zwischen 70 und 90, und besonders bevorzugt zwischen 75 und 85 liegt.

14. Akustisches Berührungssystem nach einem der vorhergehenden Ansprüche, **dadurch gekennzeichnet, dass** die Steuereinrichtung (4, 4') auf der Leiterplatte (5) vorgesehen ist, oder dass die Steuereinrichtung (4, 4') von der Leiterplatte (5) getrennt ist, wobei der akustische Sensor (2, 22, 23) mit der Steuereinrichtung (4, 4') kommuniziert.

15. Akustisches Berührungssystem nach einem der vorhergehenden Ansprüche, **dadurch gekennzeichnet, dass** akustische Hilfssensoren (2a, 2b, 2c, 2d) um den dem entsprechenden Berührungsbereich (9, 91, 92) zugeordneten akustischen Sensor (2, 22, 23) angeordnet sind.

16. Akustisches Berührungssystem nach einem der vorhergehenden Ansprüche, **dadurch gekennzeichnet, dass** die Steuereinrichtung (4, 4') abhängig von den Amplitudengrößen und/oder zeitlicher Abfolge und/oder Phasen und/oder Dämpfungseigenschaften der Signale aus dem akustischen Sensor (2, 22, 23) und den akustischen Hilfssensoren (2a, 2b, 2c, 2d) die Positionierungsgenauigkeit der Berührungsbetätigung verbessern kann.

17. Akustisches Berührungssystem nach einem der vorhergehenden Ansprüche, **dadurch gekennzeichnet, dass** das Panel (1) aus Metall, Kunststoff, Glas oder Holz besteht.

18. Akustisches Berührungssystem nach einem der vorhergehenden Ansprüche, **dadurch gekennzeichnet, dass** der akustische Sensor (2, 22, 23) ein Mikrofon, vorzugsweise ein mikroelektromechanisches System-Mikrofon, ist.

19. Haushaltsgerät, **dadurch gekennzeichnet, dass** es ein akustisches Berührungssystem nach einem der vorhergehenden Ansprüche umfasst.

20. Haushaltsgerät nach Anspruch 19, **dadurch gekennzeichnet, dass** das Haushaltsgerät eine Waschmaschine, eine Geschirrspülmaschine, ein Kühlschrank, eine Klimaanlage, ein Induktionsherd oder ein Gasherd ist.
